# EUROPEAN PATENT APPLICATION

(11) **EP 0 866 487 A1**
(43) Date of publication of application: **23.09.1998**
(21) Application number: 97402568.6
(22) Date of filing: 29.10.1997
(51) Int. Cl.: H01J 9/24

(54) **Method of making electronic and glass structures on glass substrates**

(30) Priority: 18.03.1997 US 820206
(71) Applicant: CORNING INCORPORATED, Corning, N.Y. 14831 (US)
(72) Inventor: Pujol Gilbert, Corning Inc., Corning, NY 14831 (US); Themond Jean-Pierre, Corning Inc., Corning, NY 14831 (US); Eid Bernard, Corning Inc., Corning, NY 14831 (US)
(74) Representative: Colas, Jean-Pierre

(57) **Abstract**

Electronic and glass structures are formed by forming a recessed pattern on a flat glass substrate using a recessed imaging surface, and the resultant recessed pattern on the glass is filled with an electrically conductive material to form electrodes. Barrier ribs may then be formed between the electrodes using a recessed imaging surface.

## Description

### Field of the Invention

The present invention relates to methods for manufacturing structures on glass, e.g. those which are comprised of dielectric and thermoplastic material with one or more electrodes buried in the vicinity of one of its surfaces, and more particularly, to a video image display screen, of the "plasma screen" type, which has at least one substrate obtained by implementation of this process.

### Background of the Invention

A process for manufacturing a screen of this type is known through document GB-A-2 079 045, said screen having two glass plates arranged facing one another, each plate bearing a grid of parallel electrodes arranged in grooves hollowed into the plate, the electrodes of one grid being perpendicular to the electrodes of the other grid. The plates are assembled and their edges sealed, and an ionizable gas is introduced into the space separating them after formation of a vacuum in this space. An appropriate control of the electrodes of the two grids makes it possible to selectively discharge the gas at the intersections of the electrodes, and therefore to display a visible image, either directly or by the intermediary of the excitation of the luminescence of phosphor products suitably arranged between the two plates. According to GB-A-2 079 045, the electrode grids are produced by forcing ribs formed on a metallic sheet into a plate of glass heated so as to be in the plastic state. The ribs thus buried in the plate are then individualized by removing portions of the metallic sheet until the ribs no longer have any physical connection between them.

One important problem which must be solved currently is that of lowering the costs of manufacturing of the "plasma" type video image display screens. In order to attain this objective, it would be desirable to be able to continuously manufacture the plates with necessary electrodes. This is difficult, if not impossible, using the process described in GB-A-2 079 045 which uses a static press to force the electrodes into the plate of glass in the plastic state and which then involves a step of engraving of the metallic sheet which is used.

The publication entitled "Fabrication of High-Conductivity, Transparent Electrodes with trenched Metal Bus Lines" by O.J. Gregory et al., published in the Journal of the Electrochemical Society, Vol. 138, No. 7, July 1991, describes the formation of the grooves which receive the electrodes by chemical or "dry" engraving, that is to say by ion bombardment, for example. These processes are also not suitable for a continuous manufacturing either.

### Summary of the Invention

In the present invention, recessed imaging surfaces are utilized to form electronic and glass structures on substrates such as glass. One aspect of the present invention relates to a method of making electronic and glass structures, and combinations thereof, suitable for use in plasma display panels. In one embodiment, for example, electrode patterns are constructed by forming a plurality of grooves in the substrate, and then filling the grooves with an electrically conductive material suitable for forming the electrodes, followed by the deposition of barrier ribs between the electrodes.

The grooves may be formed, for example, by heating the substrate to a deformable state, at least in the surface region of the substrate where the electrode is to be formed, and embossing the substrate with a ribbed roller to form the grooves. In another embodiment of the present invention, the grooves are formed by depositing a ribbed inorganic structure on the substrate which defines the groove pattern, e.g. by depositing glass frit structures from an intaglio recessed imaging pattern. In still another embodiment of the present invention, the grooves are formed by depositing a glass frit layer on a substrate and embossing the glass frit layer using an intaglio recessed imaging pattern.

The resultant grooves are then filled with a paste of an electrically conductive material, e.g. by forcing the conductive material into the grooves using a doctor blade.

Barrier ribs made of dielectric material can then be deposited from a recessed imaging plate onto the substrate after formation of the electrodes. The barrier ribs preferably are staggered, or imbricated with respect to the electrodes so that any two adjacent electrodes are separated by a barrier rib which is arranged parallel to the electrodes. A substrate for the electrodes and the barrier ribs can thus be made to form the back plate element of a plasma-type video image display screen.

Using the methods described herein, it is possible to produce glass plates comprised of a grid of several hundred parallel electrodes, each having a pitch of 250 µm; a width between 50 µm and 200 µm and a thickness (depth) of 10 µm, with the exterior surface of this electrode being even with the surface of the plate. It is also possible, using the methods described herein, to deposit barrier ribs having a height of 200 µm and a width of 50 µm between each of the electrodes. The methods described herein make it possible to perform continuously, on the same manufacturing line, all of the operations necessary for the production of display substrates varying electronic and structural configurations. The speed of continuous manufacture of the substrate can reach 10 m/min, ensuring a large volume of production which is entirely automated and therefore of reduced cost.

### Brief Description of the Drawings

Figure 1 illustrates a continuous manufacturing process in accordance with the present invention.

Figures 2, 3, 4, and 5 are partial enlarged sections along cutting lines II, III, IV, and V, respectively, of Figure 1.

Figure 6 illustrates a method for depositing glass structures in accordance with the invention.

Figure 7 illustrates a method for depositing glass structures in accordance with the invention

### Detailed Description of the Drawings

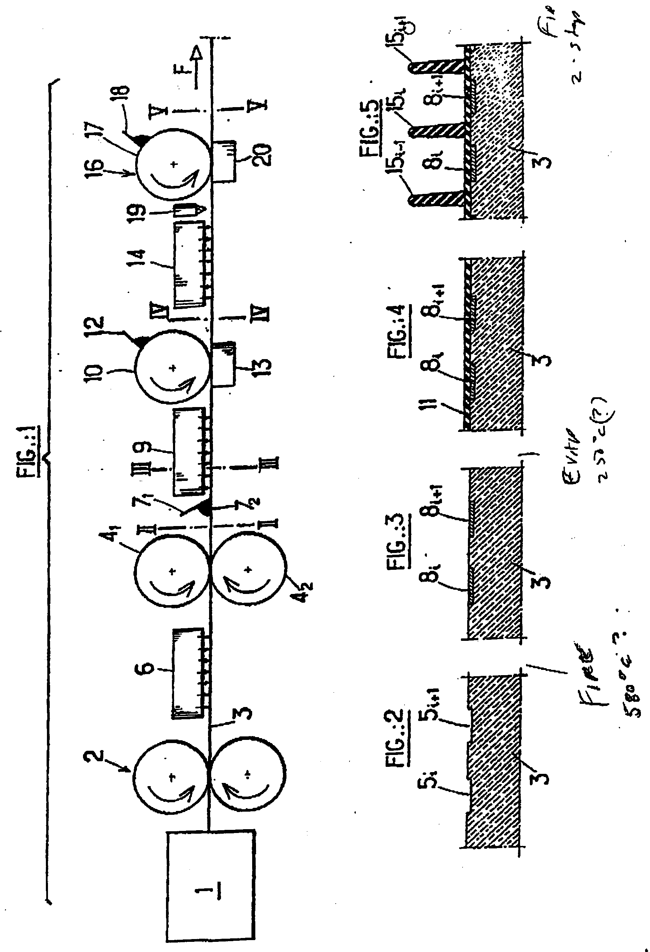

Figure 1 illustrates a method in accordance with the invention. Substrate 3, which is manufactured by manufacturing process 1, is preferably a dielectric material such as glass. Preferred glasses for substrates are soda lime glass and glasses of similar thermal expansion, but could be other glass, including Code 7059, 1737 or 1732 glasses which are manufactured by Corning Incorporated of the United States of America.

Substrate 3 can be a continuous flat glass sheet (such as is produced in a glass sheet manufacturing process), or alternatively substrate 3 can be a series of such flat plates, running separately and continuously through the process illustrated in Figure 1. If the substrate 3 is in the form of a continuous sheet after structure formation, the sheet can be sectioned into individual plates. In both cases, the substrate can be produced by any known means, for example, by simple rolling, by the float glass manufacturing process, via the downdraw process or by other means.

Substrate 3 delivered from input device 1 and conveyed successively between a pair of rollers 2 and another pair of rollers (4₁, 4₂) formed by roller 4₁ and counter-roller 4₂ which are positioned to squeeze the glass between them.

In a preferred embodiment, roller 4₁ is engraved with at least one annular rib or recessed region (not shown) to enable embossing of the substrate. More preferably, the roller 4₁ is provided with a plurality of parallel ribs which are separated by corresponding parallel recessed regions. It is therefore capable of embossing, into substrate 3 which passes between rollers 4₁ and 4₂, a pattern of grooves 5₁, 5₂, ... 5ᵢ, ... corresponding to raised rib regions on roller 4₁ and descending below the surface of substrate 3 which comes in contact with roller 4₁, as represented in Figure 2, which is a cross section of substrate 3 taken immediately downstream from rollers 4₁, 4₂.

The engraved rollers 4₁, 4₂ and 17 are preferably made of a metallic alloy such as steel X 13. The grooves or ribs to be produced on these rollers are formed by a conventional mechanical machining operation, by engraving (e.g. masking and sandblasting), by electrochemical machining, or else by metal addition. The temperature of operation of the rollers 4₁, 4₂ is preferably maintained between approximately 450 and 550°C in the case of direct embossing of a heated substrate.

Of course, this embossing operation is only possible if at least the surface of substrate 3 which passes against roller 4₁ is in a plastic deformable state. Consequently, the surface region of the glass substrate which passes between rollers 2 or 4₁, 4₂ preferably has a viscosity between 5.10⁴ and 10^{7.6} poises, enabling it to be deformed by said rollers. For this purpose, it may be necessary to heat the region of the substrate (e.g., via induction heating station 6) in the vicinity of this surface, at least to the depth of engraving foreseen, using infrared radiation heating source 6, for example, or by any known process for rapidly increasing surface temperature.

After the embossing operation the resultant grooves 5ᵢ are preferably filled with paste 7₂ of an electrically conductive material, such as silver, for example, via doctor blade 7₁. Grooves 5ᵢ are thus filled, preferably level to the surface of the substrate, with conductive frit paste 7₂ so as to form parallel electrodes 8ᵢ, 8ₗ₊₁. As shown in Fig. 3, these electrodes are at least approximately even with the surface of the substrate.

If desired, the electrode material may be consolidated, for example, by resistance heater 9, to evaporate any organic carrier and solvents contained in the conductive paste 7₂, and consolidate the electrode material into a more conductive material.

In some applications, for example the production of back plates for plasma displays, it may also be desirable or necessary to electrically insulate electrodes 8ᵢ thus formed in the glass substrate, for example to prevent diffusion of the metal which forms these electrodes back into the glass.

Alternatively, if desirable it is possible to deposit on the sheet of glass a barrier layer which prevents diffusion of metallic ions out of the glass. Such a barrier layer could be achieved, for example, by vapor depositing a layer of SiO₂ over the embossed substrate prior to depositing the conductive material which makes up the electrodes.

In a preferred embodiment, a glass frit is deposited on the glass prior to heating station 6 and the frit is then preheated (for example, by induction heating station 6) to lower the viscosity of the frit to a region at which it is formable. For example, the layer of glass frit may be deposited during manufacturing process 1 or via roll 2. After heating, the frit layer is embossed by roller 4₁ to form the recessed regions 5ᵢ-5ᵢ₊₁. By selecting the frit to be of an appropriate dielectric material, the frit will act as the barrier layer between the glass substrate and the electrodes. For example, the glass frit may be based on lead and titanium borate, and loaded with alumina in a thermoplastic medium (for example, MX 4462 available from Cerdec Company). In a preferred embodiment, a layer of this glass frit is deposited about 40-50 microns thick and then heated to approximately 60°C after which the frit is embossed to form a plurality of parallel recessed channels. In a preferred embodiment, the roll 4 is positioned to emboss the recessed channels to about 40 microns deep and about 50-80 microns wide, each recess being separated from the next recess by a distance of about 200 microns. Residual glass frit about 1 to 10 microns thick is preferably left in the areas under the recessed channels to act as a barrier layer between the conductive frit paste 8 and the glass substrate 3. After deposition of the ribs, if desired the entire structure may be exposed to a higher temperature for a period of time (e.g. 550°C for 15 minutes) sufficient to burn off organic binders and consolidate inorganic constituents.

The grooves are then filled with a conductive paste (e.g. silver conductive paste) as explained above. In one embodiment, after formation of the electrodes, the electrodes 8ᵢ formed in grooves 5ᵢ are covered with an electrically insulating material. In one embodiment, for example, substrate 3 is coated with layer 11 of a dielectric as shown in Figure 4. Such a dielectric material can be deposited, for example, via transfer roller 10, coated by doctor blade 12 with a frit comprised of dielectric material dispersed in a binder, said binder being thermoplastic or, alternatively polymerizable under ultraviolet radiation which is emitted by UV radiation source 13. In this way, the electrodes 8ᵢ are covered with a layer of dielectric frit material, thereby electrically insulating the electrode materials from the plasma channel. If desired, the frit layer can be consolidated by heating of the layer thus produced sufficiently to burn off organic constituents, for example, via convection heater 14.

A glass plate carrying a grid of such insulated electrodes, as shown in Figure 4, can be used to form the front plate of a plasma-type video image display screen. Alternatively, by providing dielectric barrier ribs 15ᵢ which project from the surface of substrate 3 as shown in Figure 5, a back plate for a plasma display can be formed. A display having plates of these two types is described in EP-A-0 554 172.

Preferably, in order to produce a plate having both electrodes 8ᵢ and barrier ribs 15ᵢ each barrier rib located between pairs of adjacent electrodes, rib forming station 16 is located downstream from station 14 for formation of such barrier ribs and deposits them onto substrate 3, which is traveling in the direction of arrow F. As an illustrative and nonlimiting example, this station can take the form of that described in U.S. Patent Application No. 08/820,206, filed March 18, 1997, titled "Method and Apparatus for Forming Glass Rib Structures", the specification of which is hereby incorporated by reference.

Station 16 includes roller 17, which is engraved with parallel annular grooves. These grooves are filled via doctor blade 18 with a glass frit in order to deposit onto substrate 3 glass frit barrier ribs 15ᵢ from the grooves of roller 17 (as illustrated in Figure 5). Preferably, each of the barrier ribs thus transferred onto substrate 3 are deposited between two adjacent electrodes 8ᵢ, 8ᵢ₊₁.To facilitate this, sensor 19 can be located upstream from roller 17 in order to detect the position of the electrodes on the substrate and to send a corresponding signal to a device (not shown) for control of the axial position of roller 17, suitable for maintaining precise alignment of the electrodes and the barriers.

As will be explained further below, the barrier ribs may be comprised of, for example, of glass powder dispersed in a binder which can be polymerized under UV radiation at UV radiation station 20.

Preferably, the resultant structure is heated sufficiently to burn off organic materials present in the metallic paste for the electrodes, as well as to ensure sintering of the dielectric layer 11 and barrier ribs 15ᵢ (if present). Consequently, in a preferred embodiment, substrate 3, which may or may not include barrier ribs 15ᵢ, can then be passed through an oven (not shown) where it is subjected to thermal cycles suitable for consolidating the assembly of the deposited materials and burning off organic constituents. After consolidation, if desired or necessary, substrate 3 can be passed through a sectioning station (not represented) where plates can be cut to desired dimensions. In the most preferred embodiments, consolidation and burnoff of the organic constituents of all of the frit layers takes place in a single heat treatment after the desired structures have been completed.

Preferred glass frit containing materials for both the grooves 5 and the barrier ribs 15 include low melting temperature glasses such as lead silicates and zinc, lead, or phosphate glasses. The frit containing materials may also be provided with a quantity of crystalline filler therein, e.g. a crystalline material selected from the group consisting of mineral, ceramic, or glass ceramic materials. Preferably, such crystalline materials should have a coefficient of thermal expansion and be employed in an amount so that, over the temperature range of 0 to 300°C, the average or resultant coefficient of thermal expansion of the frit containing material is between about 32 to 50 X 10 ⁻⁷/°C for field emission or plasma addressed liquid crystal display applications, and about 77 to 90 X 10 ⁻⁷/°C for plasma display applications. More preferably, the coefficient of thermal expansion for the frit containing material preferably is between about 35 to 45 X 10 ⁻⁷/°C for field emission or plasma addressed liquid crystal display applications, and between about 80 to 85 X 10 ⁻⁷/°C for plasma display applications over this temperature range.

In the present invention, such crystalline or glass inorganic materials are preferably employed in the frit containing mixtures at a level of at least 40 percent by weight inorganic frit, more preferably greater than 55 weight percent, and most preferably greater than 70 weight percent inorganic frit particles, the remainder being organic carrier.

The organic carrier for the frit containing material 22 may consist of, for example, a wax, a binder in solvent, a binder in wax, or a binder in plasticizer, which may further contain a radiation curable oligomer or monomer. In general, if thick structures over 20 microns are desired, and the organic binder is to be removed by pyrolysis, thermoplastic binders in solvent, wax or plasticizer are preferably employed as these organics are more readily pyrolyzed without excessive carbon formation.

In a preferred embodiment for making the barrier ribs 15, however, radiation curable binder materials are employed. The most preferred of these radiation curable containing materials are "hybrid" materials, that is, a hybrid of an UV curable formulation and a thermoplastic formulation system. This hybrid binder system has properties which allow it to be deposited (e.g., printed in a pattern) similar to standard plasticized thermoplastic binder systems. As it contains a significant quantity of UV curable monomers, the hybrid binder has a "controlled fast set" characteristic, with the "fast set" achieved by exposing the material to an appropriately selected UV light source. Until exposed to the UV light, the UV curable monomers behave as a plasticizer, with no significant changes in rheology or other properties over time.

Through proper selection of the thermoplastic resin and the UV curable monomers in such hybrids, and formulating to an appropriate ratio of these components to achieve a low to moderate crosslink density, the binder system can have "burnout" properties equal to thermoplastic binder systems. Investigation of these hybrid systems has found that excellent "burnout" performance can be achieved using systems that have an acrylic resin such as poly(butyl methacrylate) and difunctional UV curable monomers which are methacrylate functional. However, it is contemplated that for other applications with different requirements for "burnout" or other properties, many other types of thermoplastic resins could be utilized. These include other acrylic resins, polyvinyl butyral, cellulosic resins, polyethyleneglycol, polypropyleneglycol, and polyalkylene carbonate. It is also contemplated that for certain applications, adequate binder formulations could be developed using UV curable monomers that are acrylate functional and/or mono- or poly-functional.
One preferred UV curable carrier material has the following composition (in parts by weight):

| | material | Function |
|---|---|---|
| 100 | polybutylmethacrylate | polymer binder |
| 60 | triethylene glycol di-2-ethylhexoate | plasticizer |
| 60 | tetraethylene glycol dimethacrylate | radiation curable monomer |
| 3 | Irgacure 369 | photoinitiator |
| 1 | isopropyl thioxanthone | sensitizer |
| Irgacure 369, a product manufactured by Ceiba-Geigy, is 2-benzyl-2-dimethylamino-1-(4-morpholinophenyl)-butan-1. | | |

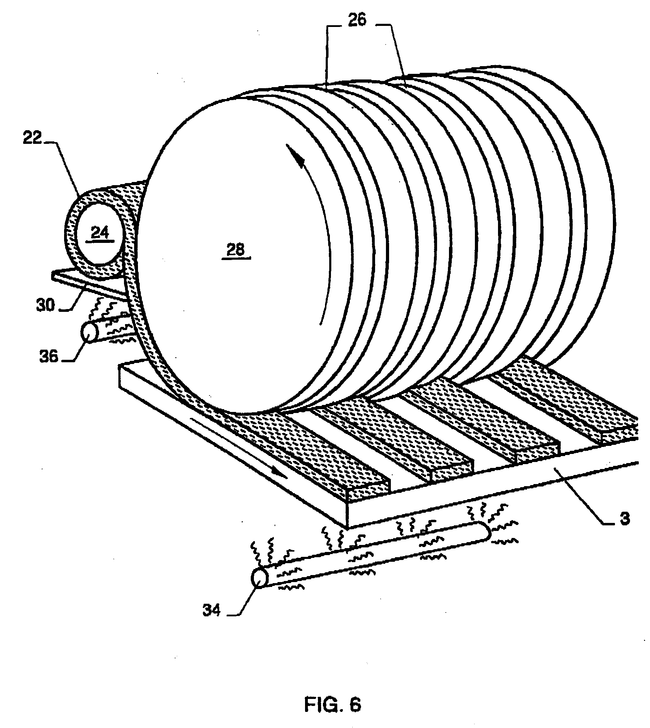

Figure 6 illustrates an alternative method for forming recessed pattern 5ᵢ - 5ᵢ₊₁. In Fig. 6, frit containing material 22 is deposited from applicator roll 24 onto recessed surface 26 of intaglio roll 28. Alternatively, the frit containing material 22 could simply be doctored into the grooves 26. Recessed pattern 26 corresponds to a desired pattern for a barrier rib structure for a plasma display panel. After deposition into recessed pattern 26, excess glass frit containing material 22 is removed from the recess by doctor blade 30. In the embodiment illustrated in Fig. 6, the frit containing material 22 is deposited onto a suitable substrate 3, which preferably is a glass sheet. The frit material should preferably develop sufficient cohesiveness while retained within the recessed pattern 26 to retain the shape of the recessed pattern 26. To facilitate this result, the glass frit containing material may be hardened prior to or during deposition to the substrate 3. For example, in the embodiment indicated in Fig. 6, the carrier for the glass frit material is curable via UV radiation and the material 22 is cured via UV light 34 simultaneous with deposition of the frit containing material to the substrate 3. Substrate 3 is transparent to the UV radiation emitted by UV light 24, thereby allowing the radiation to travel through substrate 3 and cure the organic carrier for the glass frit containing material 22. Of course such radiation curing could be achieved by other means, e.g., by emitting radiation from a suitable radiation source (not shown) at the nip between roll 28 and the substrate 3.

Alternatively, hardening of the glass frit containing material 22 can be achieved utilizing thermoplastic carriers and cooling the carriers to set them within the recessed pattern 26. Consequently, when the curing or hardening of the glass frit containing material 22 is complete, the glass frit containing material 22 will retain the shape of recessed pattern 16 during and after transfer to the substrate.

In another embodiment, the glass frit containing material 22 is hardened or cured prior to being deposited to the substrate 22, such as, for example, by UV light 36. In such cases, prior to transfer of the frit containing material 22 to the substrate 3, it may be desirable to apply an adhesive layer either to the substrate or the glass frit containing material. The adhesive can be a tacky pressure sensitive adhesive which adheres to the substrate upon applying pressure, or it can be formulated to cure upon contact. In the later case, using a radiation curable adhesive is preferred. In all cases, it is often desirable that the adhesive layer also contain frit to facilitate adhesion retention upon binder removal and ultimate post-fired adhesion between the structures and the glass substrate. It may also be desirable that this frit be a lower melting frit to enhance post-fired adhesion. The adhesive used can be, for example, a material selected from the group consisting of polyimides, epoxides, acrylics, vinyl ethers, polyurethanes, polyesters, acrylated or methacrylated acrylics, esters, urethanes, and epoxides, or mixtures thereof. Plasticized polyalkylmethacrylate polymers are generally preferred due to advantages in binder removal. If a reactive adhesive is desired these are generally blended with polyfunctional methacrylate monomers, photoinitiators, and so forth.

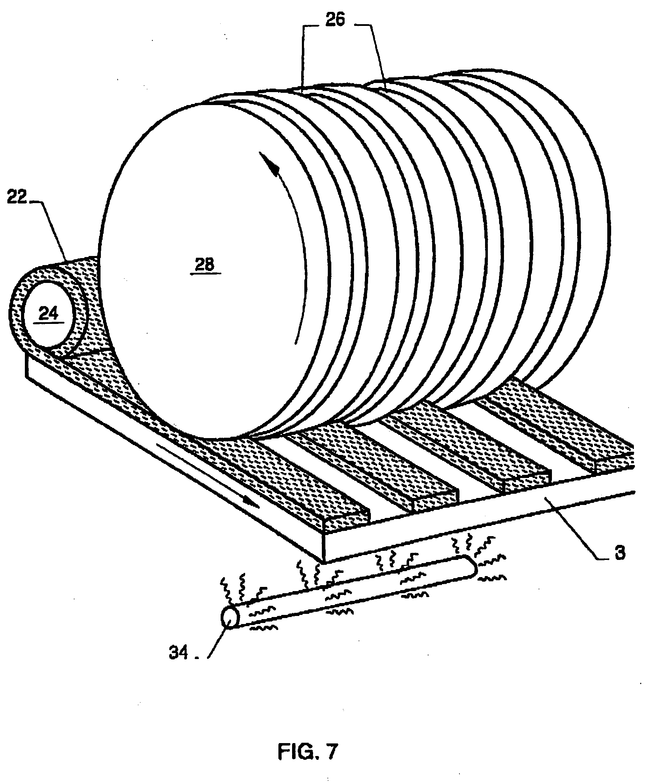

An alternative method in accordance with the invention is illustrated in Figure 7. In this method, a coating or layer of frit containing material 22 is deposited from applicator roll 24 directly onto substrate 3. In the embodiment illustrated in Fig. 7. recessed pattern 26 corresponds to a desired pattern for a barrier rib structure for a plasma or field emission or plasma addressed liquid crystal display panel. The recessed surface 26 of intaglio roll 28 contacts the frit containing material 22 and embosses it to form a free standing structure corresponding to the recessed pattern 26. If needed or desired, the frit coating material 22 may be heated prior to contact with roll 28, to impart sufficient flowability of the frit containing material. This may be achieved. for example via radiant hating, or via hot air being blown onto the layer prior to being contacted by the intaglio roll.

This method is particularly useful for forming the barrier ribs utilizing thermoplastic frit containing materials. Thus, for example, applicator roll 24 can be employed to deposit a glass frit dispersed within a thermoplastic carrier material approximately 60 to 120 microns thick. In a preferred embodiment for making ribs 180 microns high having a pitch of about 200 microns, a glass frit dispersed within a thermoplastic organic carrier is deposited to a depth of about 60 microns prior to being contacted by the intaglio plate. This frit can then be heated prior to being contacted by intaglio roll 28, to impart sufficient flowability to the glass frit so that it retains the shape of recessed pattern 26 after being contacted by the intaglio roll 28.

The intaglio image device 28 may be formed, for example, from a material of moderate release, such as HALAR, TEDLAR, TEFZEL, polyethylene, etc. Alternatively, it may be comprised of one of a number of materials noted for high release, such as silicones or fluorocarbons. The desire is to make the adhesion between the frit containing material and the patterned plate less than between the frit-containing material of the substrate and/or adhesive. The intaglio image can be formed using many techniques, such as manufacturing the plate from one of these materials or coated them thereon. One example is embossing by heating one of the above materials at a temperature above the flow point of the polymer and applying the material under pressure against a rigid master mold pattern. The intaglio surface could alternatively be an etched metal, foil or sheet of glass on which a release coat was applied. The embossed polymer layer is preferably backed with an elastomeric material to impart compressibility.

The final thermal cycle for consolidation of the substrate can include a plateau at 320° in order to facilitate removal of organic constituents and then a temperature rise up to 550-650°C or more for the consolidation of the silver paste as well the dielectric layer and barrier ribs.

The invention is further illustrated by the following example, which is not meant in any way, to limit the invention as defined by the claims.

### Example

A 150 mm by 120 mm by 3 mm thick sheet of conventional soda-lime-silica float glass was used as the substrate. To form the recesses 5ᵢ, a thermoplastic glass frit containing material was deposited onto the glass substrate at a thickness of about 50 microns. This layer acts as both material from which to form the recesses 5 as well as a barrier layer between the electrodes 8 and glass substrate 3. The glass frit containing material employed was Cerdec V725PEG enamel. The thermoplastic frit and glass substrate were then preheated to about 70°C afterwhich the frit containing material was embossed by a cylindrical embossing device 4₁ (similar to the method illustrated in Fig. 7) to form the channels 5ᵢ. The resultant channels were about 40 microns deep, with about 10 microns barrier layer of residual frit material located between the bottom of each recess and the glass substrate. The resultant structure was then fired at 550°C for 15 minutes to remove organic binders from the frit and consolidate inorganic constituents. The frit was then allowed to cool to about room temperature, afterwhich silver paste was doctored in to the grooves 5. The silver paste used was the following mixture:
17 parts silver paste No. 506 from Cerdec.
3 parts glass frit VR725 from Cerdec.
5 parts MX4462 wax medium from Cerdec.

Before depositing the barrier ribs, the electrode 8ᵢ and frit mixture were heated to about 200-300°C for about 15 minutes to consolidate materials and burn off organic constituents.

Barrier ribs 15ᵢ were then deposited over the dielectric layer using the process illustrated in Fig. 7. The thermoplastic glass frit containing material employed was a mixture of Cerdec MX4462 wax, manufactured by Cerdec France, S.A. The Cerdec MX4462 wax is desirable because of its relatively sharp phase transition at about 53°C from solid to liquid. The glass frit employed was Cerdec VR725 frit, a glass frit high in PbO and SiO₂, which is available from Cerdec France, S.A., and has a frit particle size which is primarily between about 1-10 microns, the average particle size being about 5 microns in diameter. A mixture of this glass frit (about eighty percent by weight glass frit) was dispersed within the wax, and the resultant glass frit containing material was coated at about 70°C (the material was heated via radiant heat prior to coating) onto the substrate to form a coating about 120 microns thick on the glass substrate. The glass frit containing coating was then molded into the desired glass rib structure by contacting the coating with cylindrical drum having a recessed intaglio patterned silicone mold thereon. The intaglio pattern corresponded to a desired glass rib structure for use in a plasma display. Just prior to being contacted by the drum, the frit containing coating was heated by blowing hot air (approximately 70-90°C) to transform the glass frit containing material into a flowable coating. The glass substrate was then contacted with the drum, moving at a rate of about 3-5 meters/min with respect to the drum as it was contacted. The result was a structure having about 250 glass frit containing ribs, each rib being about 50 microns wide by 200 microns high by 5 cm long, the ribs being separated by a distance of about 220 microns. A thin layer (about 10 microns thick) of frit was left in the area between ribs. This frit layer acts as an electrical insulating layer between the electrodes 8 and the channels formed by the barrier ribs 15.

The entire rib and electrode structure was then fired to consolidate materials and remove the remaining organic constituents.

The firing schedule employed was as follows:
- the ribs were placed directly into an oven which had been preheated to about 250°C.
- 1 hour ramp up from 250°C to 350°C.
- 1/4 hour hold at 350°C.
- 1 hour ramp up from 350°C to 550°C.
- 10 minute hold at 550°C.
- 2 hour ramp down to room temperature.

The rib structure maintained substantially the same dimensions and shape as was present prior to the firing, each rib being about 50 microns wide by about 170 microns high by 5 cm long, the ribs being separated by a distance of about 220 microns. It is not uncommon for ribs formed in this manner to exhibit a very small degree of shrinkage and/or slumping. Thus, for example, the ribs described above may shrink slightly in height, and may become slightly wider at their base than the remainder of their height. However, this change in dimensions is relatively insignificant, and ribs formed above are entirely suitable for use in electronic display applications. Further, this may be improved upon by initially forming the ribs to be slightly larger so that, after firing, they shrink to the desired dimensions.

Although the invention has been described in detail for the purpose of illustration, it is understood that suck detail with solely for that purpose and variations can be made therein by those skilled in the art without departing from the spirit and scope of the invention which is defined by the following claims.

## Claims

1. A process for manufacturing electronic structures for flat panel displays, comprising:
forming a recessed pattern on a flat glass substrate via contact with a recessed imaging surface; and
filling said recessed pattern with an electrically conductive material.

2. The method of claim 2, wherein said forming a recessed pattern step comprises embossing the substrate with said recessed imaging surface to form said recessed pattern.

3. The method of claim 2, further comprising, prior to said embossing step, heating said substrate to a temperature at which said glass is in a deformable plastic state.

4. The method of claim 2, wherein said forming a recessed pattern step comprises depositing a glass frit containing material onto said substrate and embossing said frit containing material with said recessed imaging surface to form said recessed pattern.

5. The method of claim 4, further comprising, prior to said embossing step, heating said substrate to a temperature at which said glass frit containing material is in a deformable plastic state.

6. The method of claim 2, wherein said forming a recessed pattern step comprises selectively depositing a glass frit containing material from said recessed imaging surface onto said substrate to form raised regions, said raised regions defining said recessed pattern

7. The method of claim 1, further comprising, prior to said filling said recessed pattern step, depositing a barrier layer onto said substrate which prevents diffusion into the substrate of the conducive material.

8. The method of claim 7, wherein said depositing a barrier layer step comprises depositing a material selected from the group consisting of SiO₂.

9. The method of either of claim 1, wherein said filling said recessed pattern step comprises doctoring a paste of an electrically conductive material into said recessed pattern.

10. The method of claim 9, wherein said conductive material comprises a particulate metal material dispersed in a binder.

11. The method of making an electrode arrangement suitable for use in a plasma display backplate in accordance with claim 1, wherein said forming a recessed pattern step comprises forming a plurality of parallel channels, whereby said electrically conductive material contained in said recessed pattern forms an electrode pattern suitable for use as a plasma display backplate electrode pattern.

12. The method of claim 11, further comprising depositing a layer of dielectric material over said substrate and said conductive material.

13. The method of claim 1, further comprising firing said conductive material at a temperature sufficient to remove organic materials from said conductive material and impart increased conductivity to said conductive material.

14. The method of claim 1, further comprising forming a plurality of dielectric barrier ribs on said substrate, said barrier ribs positioned between said conductive material.

15. The method of claim 14 wherein said forming barrier ribs step comprises:
depositing a glass frit containing material on said substrate; and
embossing said glass frit containing material.

16. A system for forming glass and electronic structures for displays, comprising:
means for forming recesses in a substrate via contact with a recessed imaging pattern;
means for depositing electrodes in said recesses; and
means for mechanically forming rib structures between said electrodes.
